# EUROPEAN PATENT APPLICATION

(11) **EP 2 878 714 A1**
(43) Date of publication of application: **03.06.2015**
(21) Application number: 13194969.5
(22) Date of filing: 28.11.2013
(51) Int. Cl.: C30B 23/00, C30B 29/36, C30B 35/00, C23C 14/24, C23C 14/06

(54) **Vapor deposition apparatus and method using the same**

(71) Applicant: Chung Shan Institute of Science and Technology, Armaments Bureau, M.N.D., Taoyuan County 325 (TW)
(72) Inventor: Hsiung, Chih-Yung, 325 Taoyuan County (TW); Ma, Dai-Ling, 325 Taoyuan County (TW); Huang, Jun-Bin, 325 Taoyuan County (TW); Chen, Hsueh-I, 325 Taoyuan County (TW)
(74) Representative: Lang, Christian

(57) **Abstract**

A deposing apparatus includes a crucible having a deposition area formed inside the crucible; a heat sink partially embedded in the crucible and capable of transferring heat from the deposition area; a heat-insulator fixedly surrounding without covering the deposing area; and a thermal reflector securely mounted on a free surface of the heat-insulator without covering the deposition area and having a reflecting face with a slope extending from a side wall of the crucible to the deposition area. The heat-insulator has a relatively low thermal conductivity relative to those of the crucible, the heat sink and the thermal reflector. The thermal reflector reflects thermal radiation in the chamber and communicates with the heat-insulator and the chamber via the pores in the thermal reflector.

## Description

### BACKGROUND OF THE INVENTION

### 1. Field of the Invention

The present invention relates to a crucible used for vapor deposition, and more particularly, to a specific design in the chamber of the crucible, which reduces the thermal gradient difference vertically and horizontally in the chamber while the crucible is heated, achieves an enhanced deposition rate due to the reduction of thermal gradient difference in the chamber, and forms a lattice-matching deposition.

### 2. Description of the Related Art

In recent years, vapor deposition has been wildly used in industry, especially in the manufacture of semiconductors. The vapor deposition method is to expose a substrate to a vapor, so that atoms in the vapor are deposited on the substrate and nucleated to form a thin layer, such as SiO₂, Polycide, Al-Cu and the like.

In the course of vapor deposition, temperature is a crucial factor that may influence the lattice uniformity to the deposit. Because the thermal gradient difference in the heated chamber containing the substrate and the vapor may cause variation of flow rate of the vapor that directly affect atom layer deposition. Accordingly, creating a smooth thermal gradient in the chamber can stabilize the vapor flow and enhances the deposition rate of the vapor flow, rendering a preferred quality of vapor deposition.

### SUMMARY OF THE INVENTION

The objective of the present invention is to provide a vapor deposition apparatus, which is designed inside the structure thereof to modify the thermal gradient distribution horizontally and vertically in a chamber of a crucible, and a method using the vapor deposition apparatus.

To achieve the foregoing purpose, the vapor deposition apparatus has a crucible, a heat sink, a heat-insulator and a thermal reflector.

The crucible has a chamber defined therein and a deposition area formed on an inner top wall of the crucible.

The heat sink is partially embedded in the crucible with a portion of the heat sink exposed to transfer heat from the deposition area.

The heat-insulator fixedly surrounds without covering the deposition area.

The thermal reflector is made of a material having pores therein, and is securely mounted on a free surface of the heat-insulator without covering the deposition area, and having a reflecting face with an upward slope extending from an inner sidewall of the crucible to the deposition area.

The heat-insulator has a relatively lower thermal conductivity than that of the crucible, the heat sink and the thermal reflector.

The thermal reflector reflects thermal radiation in the chamber and communicates with the heat-insulator and the chamber via the pores.

To achieve the foregoing objective, the method using the vapor deposition apparatus has steps of :
preparing a substrate securely placed on the deposition area and a source having at least one material symmetrically placed at a bottom of the chamber;
heating the crucible to a first temperature and providing a first chamber pressure in 15-120 minutes to vapor the source;
decreasing the first chamber pressure to a second chamber pressure in 1 minute;
heating the temperature of the crucible 12 to a second temperature in 5-120 minutes for first nucleation;
decreasing the second chamber pressure to a third chamber pressure in 5-120 minutes for second nucleation; and
heating temperature of the crucible to a third temperature while decreasing the third chamber pressure to a fourth chamber pressure for third nucleation.

A deposition rate in the third nucleation is relatively higher than the deposition rate in the first and second nucleation.

### BRIEF DESCRIPTION OF THE DRAWINGS

The invention, as well as its many advantages, may be further understood by the following detailed description and drawings in which:
Fig. 1 is a cross-sectional side view of a crucible in accordance with the present invention; and
Fig. 2 is a chart showing the relationship between the operation time of the crucible in Fig. 1 and the temperature and pressure within the chamber of the crucible in accordance with the present invention.

### DETAILED DESCRIPTION OF THE INVENTION

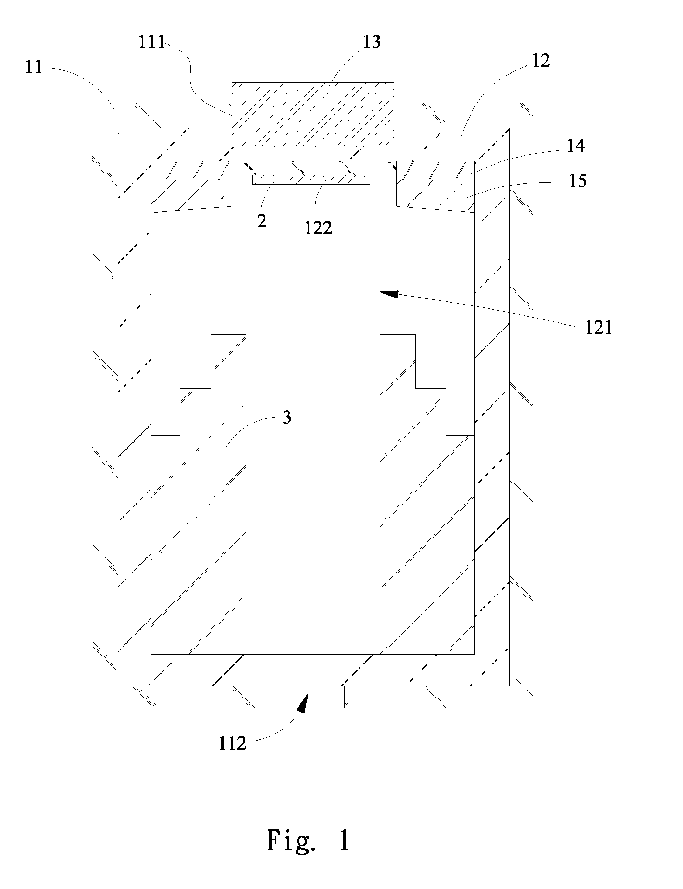

With reference to Fig. 1, a vapor deposition apparatus in accordance with the present invention has a housing 11, a crucible 12, a heat sink 13, a heat-insulating ring 14 and a thermal reflector 15.

The housing 11 is made of a heat-insulating material, which is conventional in the art, and has a first opening 111 formed through a top of the housing 11 and a second opening 112 formed through a bottom of the housing 11.

The crucible 12 is securely mounted inside the housing 11 and has a chamber 121 defined therein. The crucible 12 has a deposition area 122 formed on and protruding downwards from an inner top wall of the crucible 12. The crucible 12 further has a recess (not numbered) formed in a top of the crucible 12 and communicating with the first opening 111 of the housing 11.

The heat sink 13 is a block made of carbide or graphite, and is mounted through the first opening 111 and is securely received in the recess of the crucible 12. The heat sink 13 is used as a thermal stress and vertical heat transfer controller dissipating the heat accumulated on the deposition area 122 via the heat sink 13 and avoiding thermal stress occurring inside a material to be deposited.

The heat-insulating ring 14 is partially mounted on the inner top wall of the housing 11 without overlapping the deposition area 122. The heat-insulating ring 14 is made of carbon. As indicated by the name, the heat-insulating ring 14 transfers and generates no heat during the deposition process. Moreover, the heat-insulating ring 14 has the capability of attracting vaporized material, such as Si, to therefore obtain a preferred vapor concentration in the vapor deposition process, since a supersaturation in the chamber 121 may influence the quality of vapor deposition.

The thermal reflector 15 is also annular and is mounted on a bottom surface of the heat-insulating ring 14. It is noted that the thermal reflector 15 has a reflecting face with an upward slope extending from an inner sidewall of the crucible 12 to the deposition area 122, and an included angle between the reflecting face and a horizontal direction is less than 30 degrees. The thermal reflector 15 is made from metal carbide or the same material making the crucible 12, which can bear a temperature in a range of 1500-3000°C. The thermal reflector 15 reflects thermal radiation from anywhere inside the chamber to a bottom portion of the chamber 121 to reduce a vertical thermal gradient difference. Furthermore, when heat is generated rapidly, the thermal reflector 15 laterally transfers the heat at the top portion of the chamber 121. As such, the horizontal thermal gradient difference in the chamber 121 can be modified and reduced.

With regard to the foregoing attracting ability of the heat-insulating ring 14, specifically, the heat-insulating ring 14 is a relatively low thermal spot in the chamber 121, such that the vaporized material, such as silicon atom, tends to move thereto and penetrates through the thermal reflector 15 and reacts with the heat-insulating ring 14 to form Silicon Carbide (SiC) as the thermal reflector 15 has intrinsic pores therein that allow particles with a certain size to penetrate.

As to the vertical thermal gradient in the chamber 121, it can be further modified via the second opening 112, which is used to dissipate the heat at the bottom of the crucible 12.

A vapor deposition method using the vapor deposition apparatus in accordance with the present invention has the following steps.

Step 1: Prepare a substrate 2 securely placed on the deposing area 122 and a source 3 symmetrically placed on the bottom of the chamber 121, as shown in Fig. 1. The source 3 includes at least one material and the ratio of the at least one material can be adjusted depending on the requirement of deposition.

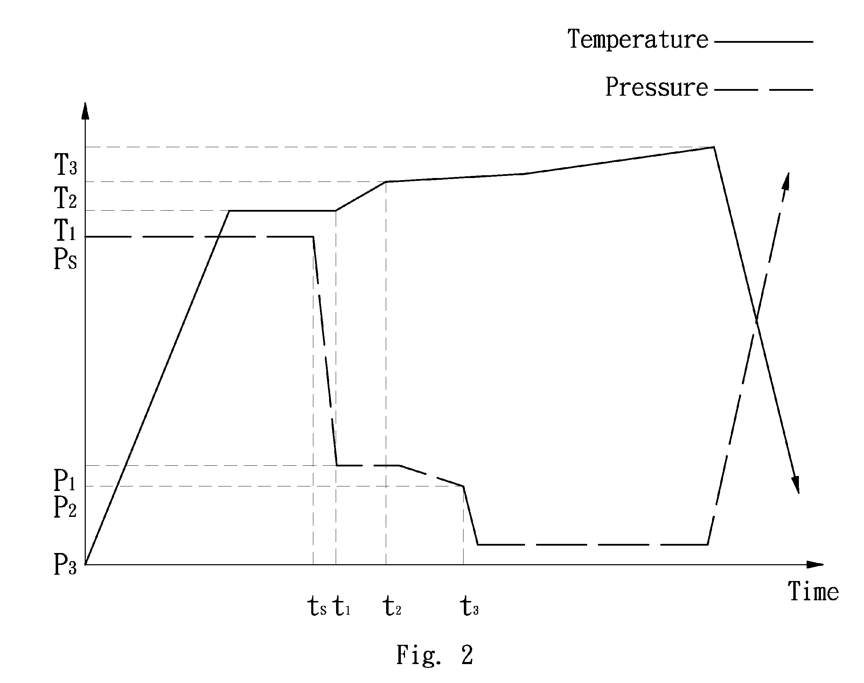

With reference to Fig. 2, a heating temperature and a chamber pressure both vary with an operation time of the vapor deposition apparatus in the rest of steps.

Step 2 (0-tₛ): Heat the crucible 12 to a temperature within 1800-2000°C (T₁) and provide the chamber pressure within 500-700 torr (Pₛ) in 15-120 minutes. The at least one material 3 absorbs the latent heat to be vapored. The means for heating the crucible 121 is conventional in the art, so the description thereof is omitted for brevity.

Step 3 (tₛ-t₁): Decrease the chamber pressure to a range of 120-200 torr (P₁) in 1 minute.

Step 4 (t₁-t₂): Heat the temperature of the crucible 12 to a range of 1900-2300°C(T₂) in 5-120 minutes for first nucleation.

Step 5 (t₂-t₃): Decrease the chamber pressure to a range of 50-120 torr (P₂) in 5-120 minutes for second nucleation.

During Steps 4 and 5, at the relatively high temperature and the relatively low pressure in the chamber 121, the vapored material can penetrate through the thermal reflector 15 to approach the heat-insulating ring 14 with a relatively low thermal gradient. Accordingly, the thermal reflector 15 has the capability of regulating the horizontal thermal gradient around the deposition area 122 and further assists lateral growth of the deposition.

Step 6 (>t₃): Heat the crucible 12 to a temperature within 1950-2380°C(T₃) while decreasing the chamber pressure rapidly within 0.1-50 torr (P₃) for third nucleation. During Step 6, the vertical thermal gradient distributed across the chamber 121 tends to be denser due to the assistance of the heat sink 13 and the second opening 112, thus greatly facilitating the deposition rate with steady nucleation.

In summary, the vapor deposition apparatus of the present invention is designed to harness the heat sink 13, the heat-insulating ring 14 and the thermal reflector 15 to horizontally and vertically modify the thermal gradient distribution in the chamber 121 of the crucible 12 while carrying out vapor deposition process. The thermal gradient difference is thereby reduced, and, meanwhile, the deposition rate is increased.

Many changes and modifications in the above described embodiment of the invention are able to, of course, be carried out without departing from the scope thereof. Accordingly, to promote the progress in science and the useful arts, the invention is disclosed and is intended to be limited only by the scope of the invention.

## Claims

1. A vapor deposition apparatus comprising:
a crucible having a chamber defined therein and a deposition area formed on an inner top wall of the crucible;
a heat sink partially embedded in the crucible with a portion of the heat sink exposed to transfer heat from the deposition area;
a heat-insulator fixedly surrounding without covering the deposition area; and
a thermal reflector made of a material having pores therein, and securely mounted on a free surface of the heat-insulator without covering the deposition area, and having a reflecting face with a slope extending from an inner sidewall of the crucible to the deposition area,
wherein the heat-insulator has a relatively lower thermal conductivity than that of the crucible, the heat sink and the thermal reflector, and
the thermal reflector reflects thermal radiation in the chamber and communicates with the heat-insulator and the chamber via the pores.

2. The deposing apparatus as claimed in claim 1, wherein the deposition area is formed on an inside wall of the crucible.

3. The deposing apparatus as claimed in claim 1, wherein the heat insulator is ring-shaped and is mounted on the inside wall of the crucible.

4. The deposing apparatus as claimed in claim 2, wherein the heat insulator is ring-shaped and is mounted on the inside wall of the crucible.

5. The deposing apparatus as claimed in claim 1, wherein the angle between the reflecting face of the thermal reflector and a horizontal direction is less than 30 degrees.

6. The deposing apparatus as claimed in claim 2, wherein the angle between the reflecting face of the thermal reflector and a horizontal direction is less than 30 degrees.

7. The deposing apparatus as claimed in claim 3, wherein the angle between the reflecting face of the thermal reflector and a horizontal direction is less than 30 degrees.

8. The deposing apparatus as claimed in claim 7, wherein the heat sink is made of carbide or graphite.

9. The deposing apparatus as claimed in claim 8, wherein the material of the heat insulator being carbon.

10. The deposing apparatus as claimed in claim 9, wherein the thermal reflector is made from metal carbide or the same material making the crucible.

11. A method using the vapor deposition apparatus as claimed in claim 1, comprising steps of :
preparing a substrate securely placed on the deposition area and a source having at least one material symmetrically placed at a bottom of the chamber;
heating the crucible to a first temperature and providing a first chamber pressure in 15-120 minutes to vapor the source;
decreasing the first chamber pressure to a second chamber pressure in 1 minute;
heating the temperature of the crucible 12 to a second temperature in 5-120 minutes for first nucleation;
decreasing the second chamber pressure to a third chamber pressure in 5-120 minutes for second nucleation; and
heating temperature of the crucible to a third temperature while decreasing the third chamber pressure to a fourth chamber pressure for third nucleation;
wherein a deposition rate in the third nucleation is relatively higher than the deposition rate in the first and second nucleation.

12. The method as claimed in claim 11, wherein the first temperature is in a range of 1800-2000°C, the second temperature is in a range of 1900-2300°C, the third temperature is in range of 1950-2380°C, the first chamber pressure is in a range of 500-700 torr, the second chamber pressure is in a range of 120-200 torr, the third chamber pressure is in a range of 50-120 torr, and the fourth chamber pressure is in a range of 0.1-50 torr.
